Europäisches Patentamt

European Patent Office

Office européen des brevets

(19)

(11) Publication number: **0 082 628**
A2

# EUROPEAN PATENT APPLICATION

(12)

(21) Application number: **82306497.7**

(22) Date of filing: **07.12.82**

(51) Int. Cl.³: **H 04 N 1/22**

(30) Priority: **17.12.81 GB 8138067**

(43) Date of publication of application:
**29.06.83 Bulletin 83/26**

(84) Designated Contracting States:
**BE DE FR GB IT NL SE**

(71) Applicant: **VICKERS PLC
Vickers House Millbank Tower Millbank
London SW1P 4RA(GB)**

(72) Inventor: **Doyle, Stephen Bernard
31 Lyndhurst Crescent Scholes
Leeds West Yorkshire LS15 4BR(GB)**

(72) Inventor: **Marsden, Robert Milton
Highways Wetherby Road
Leeds West Yorkshire LS17 8LY(GB)**

(74) Representative: **Billington, Lawrence Emlyn et al,
HASELTINE LAKE & CO Hazlitt House 28 Southampton
Buildings Chancery Lane
London WC2A 1AT(GB)**

(54) **Improvements in or relating to the processing of light-sensitive media, for example lithographic printing plates.**

(57) In the processing of light-sensitive media, for example lithographic printing plates, the active components of the developer are used up and need replenishment, particularly when silver halide or similar technology is involved.

The modulation signal of a laser used to expose the light-sensitive media is integrated to provide a signal indicative of the exposed image area to be developed and this signal is used to control the addition of replenishment material. Replenishment required to overcome the degradation of the active components with time may also be incorporated. In a preferred embodiment of a replenishment control circuit a laser beam modulator 31 supplies a modulation signal to an integrator comprising a high output frequency sampler 32, a counter 33 and a laser-on counter 34a. A developer circulating pump 35 and a replenishment pump 36 are controlled by a microprocessor 34 which contains the laser-on counter 34a and a replenishment dose required counter 34c fed by the counter 34a and a time base generator 34b which provides a purely time-dependent component of the replenishment required count. A replenishment dose control counter 34d controls operation of the pumps 35 and 36 in dependence upon the content of the dose required counter 34c.

EP 0 082 628 A2

*FIG. 3.*

Improvements in or Relating to the Processing of Light-
Sensitive Media, for example Lithographic Printing Plates

This invention relates to the processing of
light-sensitive media, for example lithographic plates.

The increasing use in recent years of electronic
methods for generating, transmitting and storing information has led to a trend in, for example, the lithographic
printing industry towards lithographic plates which can
take advantage of such methods. In particular the trend
has been towards plates which can be exposed to light
using a laser.

Two types of plates which are produced in the
lithographic printing industry, this particular industry
and product having been cited by way of example only,
are electrostatic plates and plates based on silver halide
and similar technology. Both these types of plates are
suitable for laser exposure and moreover are additive, i.e.
the image material is deposited onto the hydrophilic
substrate as distinct from the conventional subtractive
plate where the light sensitive material is removed from
the non-image areas.

As the image-forming material is being withdrawn
from the developer, it is necessary that the developer
has its active components replenished at intervals. It
is desirable that this replenishment is carried out
accurately as too much or too little can produce inconsistent development results.

In particular, too little replenishment could produce a weakened image and too much replenishment could be

-2-

wasteful, particularly in the case of silver halide type plates.

One way of assessing the amount of replenishment required is based on the number of plates that have been processed. However, this lacks accuracy as the actual image area on each plate can vary widely.

The provision of accurate replenishment may also be a problem with respect to processing of other light-sensitive media, for example films, and also in electrostatic copiers in which accurate toner replenishment may be desirable.

It is an object of this invention to provide a method and apparatus for accurate replenishment in dependence on the actual image area.

According to one aspect of the present invention, there is provided a replenishment method comprising taking an input signal modulating the beam of a laser used for exposing a light sensitive medium, integrating said signal to provide measurement of the image area of the light sensitive medium, and using said integrated signal to control means for adding replenisher material.

In, for example, the case of developing lithographic plates, whilst replenishment of the developer in dependence on the image area processed is applicable to both electrostatic and silver halide developers, in the case of the latter developers, it may also be necessary to replenish the active components on a regular time basis regardless of the image area processed, due to the fact that they become degraded with time and by environmental factors e.g. contact with the atmosphere.

According to a development of the invention therefore, the replenishment method further includes adding a predetermined amount of replenisher material at predetermined intervals, independently of the image area  processed.

According to a further aspect of the invention, there is provided a replenishment control circuit comprising an integrating circuit for integrating an input modulation signal for a laser used for exposing a light sensitive medium, and means for converting the integrated signal into a signal capable of controlling means for adding replenisher material.

According to a development, the control circuit includes a signal conditioning circuit for converting the input signal to a signal having standard amplitude and polarity.

According to a further development, the signal converting means comprises a level trigger circuit for converting the analogue integrated signal to digital form, a counter, a pulse stretcher for extending the length of the counter output pulse, and a pump controller circuit.

In an alternative embodiment, said integrator comprises: a sampling circuit comprising a high frequency pulse generator and an AND gate, the output from said sampling circuit being, in use, in the form of bursts of pulses, the number of said pulses in said bursts being representative of the length of pulses in said input modulation signal; a multiple bit binary counter for summing said pulses from said sampling circuit and for producing an output pulse when a predetermined count capacity is reached; and a laser-on counter for summing the output pulses from said binary counter and for producing an output signal when a pre-set count is reached.

In the alternative embodiment, the integrated-signal converting means may comprise a replenishment dose-control counter and a tachometer associated with a replenishment pump, the output signal from said laser-on counter controlling loading of said dose-control counter to a pre-set figure to start said replenishment pump, the signal from said tachometer being used to decrement said dose-control counter to zero.

There may be a time-base signal generator for producing signals at regular intervals, said signals being fed with the signal from said laser-on counter to a replenishment dose-required counter which controls the loading of said replenishment dose-control counter, the count in said dose required counter being indicative of the replenishment required due to the active components of the developer being used up by developing the image area and/ or by time and environmental degradation.

For a better understanding of the invention and to show how the same may be carried into effect, reference will now be made, by way of example, to the accompanying drawings in which:

Fig. 1 is a flow diagram of a complete copy to plate system with plate image area dependent replenishment for use in producing, by way of example, a finished lithographic printing plate;

Fig. 2 is a block diagram of a first embodiment of the replenishment control circuit; and

Fig. 3 is a block diagram of a second embodiment of the replenishment control circuit.

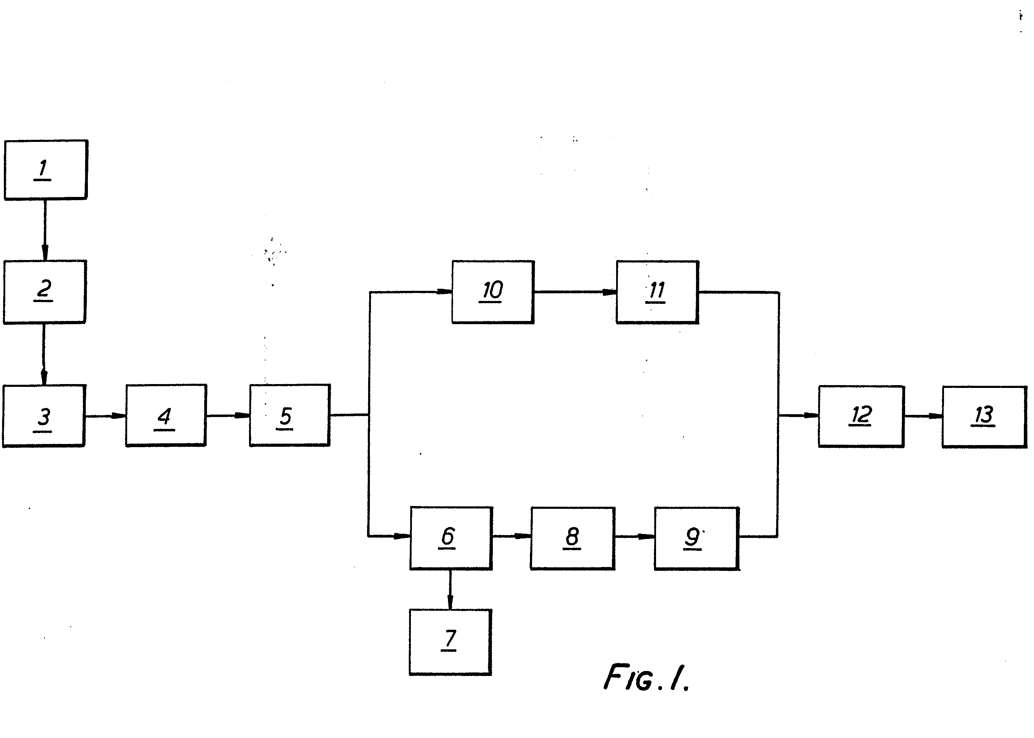

Referring to Figure 1, a copy 3 to be reproduced on a lithographic printing plate is scanned by a read laser 1 under the control of a scanner 2. The beam reflected from the lighter areas of the copy 3 is passed to a photo-multiplier 4 which thus produces an analogue signal which is a function of the variation of the lighter and darker areas of the copy. This analogue signal is passed to an analogue/digital converter 5 which produces a digital output signal capable by means of a modulator 6 of modulating a write laser 7, which under the control of a scanner 8, co-ordinated with the read scanner 2, is used to expose the printing plate 9.

The above system may vary in known ways and for further details reference may be made to "High Speed Laser Printing" by K. Starkweather in Volume 4 of Laser Applications, edited by Joseph W. Goodman and Monte Ross and published by Academic Press.

In the present method and apparatus, the modulator drive signal, i.e. the output from the analogue/digital converter 5, is processed by a replenishment control circuit 10 to provide a signal which is representative of the area of the plate exposed and which is capable of controlling means for adding replenisher to a plate processor 12, for example a pump 11, to produce a processed plate 13.

For optimum utility, the replenishment control circuit 10 will need to be ab   to handle input signals of different parameters derived from different laser systems and be able to drive various types of replenishment pumps.

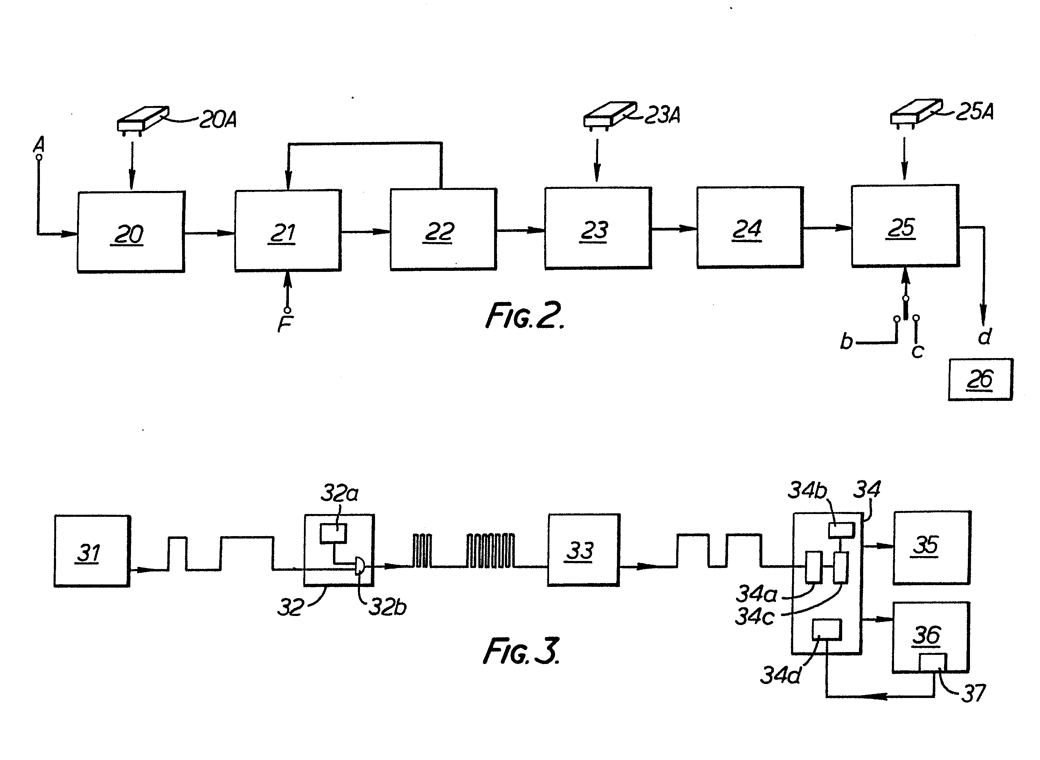

A suitable replenishment control circuit 10 is shown in Figure 2. The signal from the AD converter 5 is connected to line A and provides the input to a signal conditioner 20. In this embodiment, therefore, the input signal to the modulator 6 is tapped to provide the input signal, modulating the laser beam, which is integrated in accordance with the present invention. Depending on the type of laser system used, this signal may be anywhere between a few millivolts and several tens of volts and of either polarity. It is necessary, therefore, to standardise the amplitude, and polarity. To accomplish this, the signal conditioner 20 has a plug-in module 20A that attenuates the signal resistively down to a preset level and inverts its polarity if necessary. The degree of attenuation may be varied to suit the particular laser system being used. The signal is amplified to a standard voltage. The construction of the signal conditioner 20 will be readily apparent to the man skilled in the art, and forms no part of the present invention.

The standardised signal is passed to a high-speed linear integrator 21 that has a full scale time constant of about 10 micro seconds. The output from the integrator is a linear integral of the input voltage with respect to time and is used to drive a level
trigger 22.

As the input voltage is uni-polar, the integrator
21 would soon saturate unless reset to zero. This
reset function is accomplished by a signal fed back
from the trigger 22. It is essential or at least
desirable that the time to reset the integrator is
insignificant with respect to the temporal resolution
of the input signal.

To achieve this, a reset mechanism is provided which uses a solid-state switch having an impedance that gives a small CR product relative to the time constant of the integrator.

The level trigger 22 converts the analogue signal from the integrator 21 to digital form for use by the rest of the system. As the integrated signal ramps up, its level is compared continuously to an accurately preset voltage level. As the integrator signal passes the preset voltage the output of the level trigger changes state; it goes from a logical 0 voltage to a logical 1 voltage. This change of state is both used as a digital output and fed back to the integrator. The signal that is fed back to the integrator is used to reset the integrator to its zero state. This of course will reduce the output voltage to zero and hence the level trigger will change its state back again to its initial state. The net effect is to produce an output pulse with a duration of the same order as the reset time of the integrator. To ensure that a proper reset of the integrator is achieved it is necessary that the level trigger exhibit a controlled amount of hysteresis.

The output pulse is fed to a binary coded decimal (BCD) counter 23 with six digits resolution, preceded by a divide by 1000 prescaler. The BCD counter is preloaded with a value defined by a module 23A. The counter then counts downwards the pulses from the level trigger via the prescaler until a count of zero is reached, at which

0082628

point the counter generates an underflow signal which is fed back to the load gate of the counter to preload the count from the module 23A. This provides a cyclical process with a constant divider that can be established at assembly time or changed in the field. The number of pulses received by the counter is exactly proportional to the amount of exposed area on the laser scan, assuming that any overscan is on white area. The constant of proportionality is governed precisely by the scanning speed which is fixed for any particular type of laser camera. By representing this constant of proportionality as the preset count in the module 23A, a signal can be derived at the output of the counter that is equivalent to a precise amount of exposed area regardless of the type of laser system. The initial state of the counter at switch on is significant as it is required to allow for an initial dose of developer or suppress this initial dose until the required area of emulsion has been exposed. To accomplish this, there is a section of the module 23A that resets the counter to zero or presets it as desired at switch on. The reset signal from the counter is used as a signal to drive a pump controller 25 via a pulse stretcher 24.

The pulse stretcher 24 is required to extend the pulse so as to provide sufficient drive to the pump controller 25. The pulse that is derived from the counter reset is only as long as the time required to reset the digital electronics of the counter. This is typically a very short time, of the order of 5 to 10 nanoseconds. The amount of energy in such a pulse is very small and hence is insufficient to drive the power electronics of the pump controller 25, or even to transmit over more than a couple of centimetres of connecting wire. For this reason the pulse is stretched from a few nanoseconds to about 10 microseconds by a fixed duration monostable. This gives a reliable pulse with known characteristics that can be fed to the pump controller 25.

The pump controller has the job of driving a developer pump 26 that is of unspecified type, but would be expected to be of the small positive displacement type, driven by a small a.c. motor. As the amount of developer that is required depends upon the chemical regime employed, the duration of the pumping cycle is variable. To satisfy this demand, the pump controller contains a 3 digit BCD counter that is preloaded with an amount of developer to dose by means of a module 25A. When a signal is received from the pulse stretcher the value in the module 25A is loaded into the pump controller counter. This counter then registers non-zero which drives a solid state switch to provide a mains output on line d. The counter then starts count down towards zero. When zero is reached the output on line d is turned off and further counting inhibited until the next pulse is received from the pulse stretcher. The signal that is used to decrement the pump controller counter can be derived from one of two sources. In the first instance a monitoring device on the pump itself, for example a reed switch in a peristaltic pump, can be used to provide a signal on line b. Alternatively, a fixed frequency signal derived from the mains electricity supply, can be used to provide a signal on line c. In this way it is possible to provide an output that is strictly governed by the pump itself or, if such a signal cannot be used then a time dependent signal is available. The choice of which method is used is governed by the module 25A.

As mentioned above, it is also necessary/to in some cases replenish the developer on a regular time basis.

The control signal for this replenishment may be by feeding a square wave having an amplitude equal to the aforesaid standard signal into the integrator on line F from a signal generator. The time dependent replenishment may be varied by altering the frequency of the square wave.

It is advantageous if the operator of the processor can add replenisher material independently of either the image dependent or time dependent replenishment. This may be done by providing the module 25A with an additional counter which is manually operable.

An alternative embodiment of the replenishment control circuit 10 of Figure 1 is indicated in Figure 3. This embodiment is designed to work on TTL (Transistor to Transistor Logic) on which many laser exposure systems operate, and, therefore, no signal conditioner is required, such as that referenced 20 in Figure 2.

As shown in Figure 3, digital write-laser-modulating pulses from the modulator 31 (which is modulator 6 in Figure 1) are fed to a sampling circuit 32 which consists of a high frequency (e.g. 10 MHz) pulse generator 32a and an AND gate 32b. The output, therefore, is in the form of bursts of pulses, the number of pulses in each burst being representative of the length of the corresponding digital pulse from the modulator 31. In this embodiment the output signal from the modulator 6 or 31 is tapped to provide the input signal, modulating the laser beam, which is integrated in accordance with the present invention.

The bursts of pulses are fed to a 16 bit counter 33 which, when 65, 535 pulses have been received, resets to zero and outputs a pulse to a microprocessor 34 which contains, and is programmed to control, a laser-on counter 34a (i.e. a counter which in combination with the sampling circuit 32 and the counter 33 sums the periods during which the laser is exposing the light sensitive medium and whose total is, therefore, representative of the image area), a time-base signal generator 34b, a replenishment dosc required counter 34c and a replenishment dose control counter 34d. In Figure 3 the integration of the modulating signal is performed by, in combination, the sampling circuit 32, the counter 33 and the laser-on counter 34a.

The pulses from the counter 33 are summed by the laser-on counter 34a and when the count reaches a pre-set figure, the counter 34a resets to zero and produces an output signal which increments the replenishment dose required counter 34c by one. This counter 34c also receives signals from the time-base generator 34b and, therefore, its content is indicative of the replenishment required due to the active components of the developer being used up both by developing the image and by time and environmental degradation. The time-base signal generator 34b provides an element of the total replenishment which is dependent only upon elapsed time.

When the dose required counter 34c reaches a pre-set total, it is reset to zero, and causes, under control of the microprocessor programme, a pre-set count to be loaded into the dose control counter 34d. A pump 35 for circulating the developer in the processor is started and, after a pre-set delay, a replenishment pump 36 is switched on.

A tachometer 37 associated with the pump 36 is used to decrement the dose control counter 34d by one for each one eighth revolution of the pump 36.
When the dose control counter 34d reaches zero, the
pump 36 is switched off; any pump overrun causing the
dose control counter 34d to be decremented to a negative
value. Thus any extra replenisher material added will
be allowed for when the dose level counter 34d is
next loaded. Finally, the developer circulation pump
35 is switched off after a pre-set delay which begins
when the pump 36 is switched off.

Clearly, the microprocessor programme can be
altered to vary the pre-set counter levels and the
delays to suit particular circumstance and laser
exposure systems.

Whilst the invention has been described in
relation to lithographic plates, it is equally
applicable to electrostatic copiers and films
employing laser exposure.

Claims:

1.      A method of controlling replenishment of active component  of a developer during processing of light-sensitive media, comprising taking an input signal modulating the beam of a laser used for exposing a light-sensitive medium, integrating said signal to provide measurement of the image area of the light-sensitive medium, and using said integrated signal to control means for adding replenisher material.

2.      A method according to claim 1, in which replenisher material is further added on a time-related basis independently of said image area.

3.      A circuit for controlling replenishment of active component of a developer during processing of light-sensitive media, comprising an integrator for integrating an input modulation signal for a laser used for exposing a light-sensitive medium, and means for converting the integrated signal into a signal capable of controlling means for adding replenisher material.

4.      A circuit according to claim 3, in which said integrator comprises: a sampling circuit comprising a high frequency pulse generator and an AND gate, the output from said sampling circuit being, in use, in the form of bursts of pulses, the number of said pulses in said bursts being representative of the length of pulses in said input modulation signal; a multiple bit binary counter for summing said pulses from said sampling circuit and for producing an output pulse when a predetermined count capacity is reached; and a laser-
on counter for summing the output pulses from said binary
counter and for producing an output signal when a pre-
set count is reached.

5.        A circuit according to claim 4, in which said
integrated-signal converting means comprises a replenishment dose-control counter and a tachometer associated with
a replenishment pump, the output signal from said laser-on
counter controlling loading of said dose-control counter
to a pre-set figure to start said replenishment pump,
the signal from said tachometer being used to decrement
said dose-control counter to zero.

6.        A circuit according to claim 5, comprising
a time-base signal generator for producing signals at
regular intervals, said signals being fed with the signal
from said laser-on counter to a replenishment dose-required counter which controls said loading of said replenishment dose control counter, the count in said dose required
counter being indicative of the replenishment required
due to the active components of the developer being used
up by developing the image area and by time and
environmental degradation.

7.        A circuit according to claim 3, comprising a
signal conditioning circuit for converting the input
modulation signal to a signal having a standard
amplitude and polarity.

8.        A circuit according to claim 3. or 7, in which said
integrator is a high speed linear integrator for
producing an analogue integral of the input modulation

**0082628**

signal.

9.     A circuit according to   claim  8, in which said integrated signal converting means comprises a level trigger circuit for digitising the analogue signal, a counter, and a pulse stretcher for extending the output pulse from said counter.

1/2

FIG. 1.

FIG.2.

FIG.3.